# EUROPEAN PATENT APPLICATION

(11) **EP 2 264 785 A2**
(43) Date of publication of application: **22.12.2010**
(21) Application number: 10006253.8
(22) Date of filing: 16.06.2010
(51) Int. Cl.: H01L 31/052

(54) **Receiver for photovoltaic concentrator system comprising III-V semiconductor solar cells**

(30) Priority: 16.06.2009 US 485684
(71) Applicant: Emcore Solar Power, Inc., Albuquerque NM 87123 (US)
(72) Inventor: Seel, Steve, Albuquerque NM 87123 (US); Buie, Damien, Hoboken, NJ 07030 (US); Blumenfeld, Philip, Albuquerque NM 87123 (US); Foresi, James, Albuquerque, NM 87123 (US); Nagyvary, John, Albuquerque, NM 87123 (US); Hoffmann W., Richard Jr., Clinton, NJ 08809 (US)
(74) Representative: Wagner, Karl H.

(57) **Abstract**

A solar cell receiver for use in a concentrating photovoltaic system that includes a ceramic substrate, a III-V compound semiconductor solar cell, and a heat sink. The ceramic substrate has a first metallized surface and an opposing second metallized surface. The first metallized surface of the ceramic substrate has separated conductive regions. The solar cell has a conductive first surface connected to a first one of the conductive regions of the ceramic substrate and an opposing second surface having a conductive contact area connected to a second one of the conductive regions. The heat sink is bonded to the second metallized surface of the ceramic substrate with a thermally conductive attach media, such as a metal-filled epoxy adhesive or solder.

## Description

### Field of the Invention

The present application is directed to a solar cell receiver, more particularly, to a solar cell receiver including a solar cell, metallized ceramic substrate and a heat sink.

### Background

Historically, solar power (both in space and terrestrially) has been predominantly provided by silicon solar cells. In the past several years, however, high-volume manufacturing of high-efficiency III-V compound semiconductor multijunction solar cells for space applications has enabled the consideration of this alternative technology for terrestrial power generation. Compared to silicon, III-V compound semiconductor multijunction cells are generally more radiation resistant and have greater energy conversion efficiencies, but they tend to cost more to manufacture. Some current III-V compound semiconductor multijunction cells have energy efficiencies that exceed 27%, whereas silicon technologies generally reach only about 17% efficiency. Under concentration, some current III-V compound semiconductor multijunction cells have energy efficiencies that exceed 37%.

Generally speaking, the multijunction cells are of n-on-p polarity and are composed of a vertical stack of InGaP/(In)GaAs/Ge semiconductor structures. The III-V compound semiconductor multijunction solar cell layers are typically grown via metal-organic chemical vapor deposition (MOCVD) on germanium (Ge) substrates. The use of the Ge substrate permits a junction to be formed between n- and p- type Ge, thereby utilizing the substrate for forming the bottom or low band gap subcell.

### Summary

According to an embodiment, a solar cell receiver for converting solar energy to electricity includes a ceramic substrate, a solar cell and a heat sink. The ceramic substrate has a first metallized surface and an opposing second metallized surface. The first metallized surface of the ceramic substrate has separated conductive regions. The solar cell has a conductive first surface connected to a first one of the conductive regions of the ceramic substrate and an opposing second surface having a conductive contact area connected to a second one of the conductive regions. The heat sink is bonded to the second metallized surface of the ceramic substrate with a highly thermally conductive attach media, such as a metal-filled epoxy adhesive or solder.

According to another embodiment, a solar cell receiver for converting solar energy to electricity includes a ceramic substrate, a solar cell, a bypass diode and a heat sink. The ceramic substrate has a first metallized surface and an opposing second metallized surface. The first metallized surface of the ceramic substrate has separated conductive regions. The solar cell has an anode terminal electrically connected to a first one of the conductive regions of the ceramic substrate and a cathode terminal electrically connected to a second one of the conductive regions. The bypass diode is connected across the first and second conductive regions of the ceramic substrate in parallel with the solar cell. The heat sink is bonded to the second metallized surface of the ceramic substrate with a highly thermally conductive attach media, such as a metal-filled epoxy adhesive or solder.

According to another embodiment, a solar cell receiver is manufactured by providing a ceramic substrate having a first metallized surface and an opposing second metallized surface, the first metallized surface having separated conductive regions. A conductive first surface of a solar cell is connected to a first one of the conductive regions of the ceramic substrate and a conductive contact area of an opposing second surface of the solar cell is connected to a second one of the conductive regions. A heat sink is bonded to the second metallized surface of the ceramic substrate with a highly thermally conductive attach media, such as a metal-filled epoxy adhesive or solder.

Of course, the present invention is not limited to the above features and advantages. Those skilled in the art will recognize additional features and advantages upon reading the following detailed description, and upon viewing the accompanying drawings.

### Brief Description of the Drawings

Figure 1 is a partially exploded perspective view of an embodiment of a solar cell receiver including a solar cell, a metallized ceramic substrate and a heat sink.

Figure 2 shows the solar cell and the metallized ceramic substrate of Figure 1 in more detail.

Figure 3 is a cross-sectional view of the solar cell, the metallized ceramic substrate and the heat sink shown in Figure 1.

### Detailed Description

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

Solar cell receivers include a solar cell for converting solar energy into electricity. In various implementations described herein, a triple-junction III-V compound semiconductor solar cell is employed, but other types of solar cells could be used depending upon the application. Solar cell receivers often contain additional components, e.g., connectors for coupling to an output device or other solar cell receivers.

For some applications, a solar cell receiver may be implemented as part of a solar cell module. A solar cell module may include a solar cell receiver and a lens coupled to the solar cell receiver. The lens is used to focus received light onto the solar cell receiver. As a result of the lens, a greater concentration of solar energy can be received by the solar cell receiver. In some implementations, the lens is adapted to concentrate solar energy by a factor of 400 or more. For example, under 500-Sun concentration, 1 cm² of solar cell area produces the same amount of electrical power as 500 cm² of solar cell area would, without concentration. The use of concentration, therefore, allows substitution of cost-effective materials such as lenses and mirrors for the more costly semiconductor cell material. Two or more solar cell modules may be grouped together into an array. These arrays are sometimes referred to as "panels" or "solar panels."

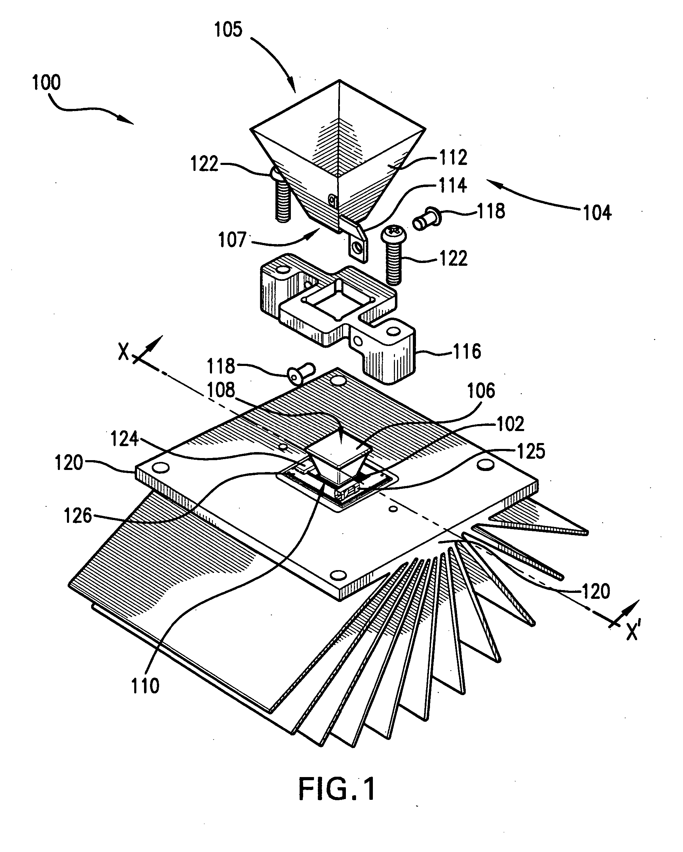

Figure 1 illustrates an embodiment of a solar cell receiver 100 including a solar cell 102. In one embodiment, the solar cell 102 is a triple-junction III-V compound semiconductor solar cell which comprises a top cell, a middle cell and a bottom cell arranged in series. In another embodiment, the solar cell 102 is a multijunction solar cell having n-on-p polarity and is composed of InGaP/(In)GaAs III-V compounds on a Ge substrate. In each case, the solar cell 102 is positioned to receive focused solar energy from a secondary optical element 104.

The secondary optical element 104 is positioned between the solar cell 102 and a primary focusing element (not shown) such as a lens. The secondary optical element 104 is generally designed to collect solar energy concentrated by the corresponding lens toward the upper surface of the solar cell 102. The secondary optical element 104 includes an entry aperture 105 that receives light beams from the corresponding lens and an exit aperture 107 that transmits the light beams to the solar cell 102. The secondary optical element 104 includes an intermediate region 112 between the apertures 105, 107. Under ideal conditions, the lens associated with the secondary optical element 104 focuses the light directly to the solar cell 102 without the light hitting against the secondary optical element 104.

In most circumstances, the lens does not focus light directly on the solar cell 102. This may occur due to a variety of causes, including but not limited to chromatic aberration of a refractive lens design, misalignment of the solar cell 102 relative to the lens during construction, misalignment during operation due to tracker error, structural flexing, and wind load. Thus, under most conditions, the lens focuses the light such that it reflects off the secondary optical element 104. The difference between an ideal setup and a misaligned setup may be a minor variation in the positioning of the lens of less than 1°.

The secondary optical element 104 therefore acts as a light spill catcher to cause more of the light to reach the solar cell 102 in circumstances when the corresponding lens does not focus light directly on the solar cell 102. The secondary optical element 104 can include a reflective multi-layer intermediate region such as the kind disclosed in U.S. Patent Application Serial No. 12/402,814 filed on March 12, 2009, the content of which is incorporated herein by reference in its entirety. The reflective multi-layer intermediate region can be formed from different materials and have different optical characteristics so that the reflectivity of the light beams off secondary optical element 104 and transmitted to the solar cell 102 optimizes the aggregate irradiance on the surface of the solar cell 102 over the incident solar spectrum. For example, in some implementations, the inner surface of the body 112 of the secondary optical element 104 can be coated with silver or another material for high reflectivity. In some cases, the reflective coating is protected by a passivation coating such as SiO₂ to protect the secondary optical element 104 against oxidation, tarnish or corrosion.

The body 112 of the secondary optical element 104 has one or more mounting tabs 114 for attaching the body 112 to a bracket 116 via one or more fasteners 118. The bracket 116 is provided for mounting the secondary optical element 104 to a heat sink 120 via one or more fasteners 122. The bracket 116 is thermally conductive so that heat energy generated by the secondary optical element 104 during operation can be transferred to the heat sink 120 and dissipated. As shown in this implementation, the secondary optical element 104 has four reflective walls. In other implementations, different shapes (e.g., three-sided to form a triangular cross-section) may be employed. The secondary optical element 104 can be made of metal, plastic, or glass or other materials.

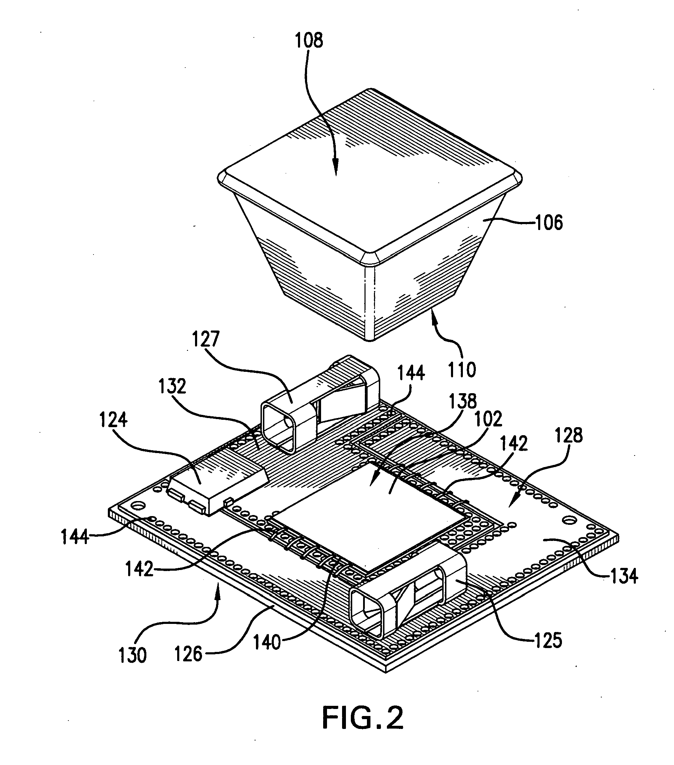

In one embodiment as shown in Figure 2, a concentrator 106 is disposed between the exit aperture 107 of the secondary optical element 104 and the solar cell 102. The concentrator 106 is preferably glass and has an optical inlet 108 and an optical outlet 110. In one embodiment, the concentrator 106 is solid glass. The concentrator 106 amplifies the light exiting the secondary optical element 104 and directs the amplified light toward the solar cell 102. In some implementations, the concentrator 106 has a generally square cross section that tapers from the inlet 108 to the outlet 110. In some implementations, the optical inlet 108 of the concentrator 106 is square-shaped and is about 2 cm x 2 cm and the optical outlet 110 is about 0.9 cm x 0.9 cm. The dimensions of the concentrator 106 may vary with the design of the solar cell module and the receiver. For example, in some implementations the dimensions of the optical outlet 110 are approximately the same as the dimensions of the solar cell 102. In one embodiment, the concentrator 106 is a 2X concentrator. The bottom surface of the concentrator 106 can be directly attached to the upper surface of the solar cell 102 using an adhesive such as a silicone adhesive. The solar cell 102 converts the incoming sunlight directly into electricity by the photovoltaic effect.

A bypass diode 124 is connected in parallel with the solar cell 102. In some implementations, the diode 124 is a semiconductor device such as a Schottky bypass diode or an epitaxially grown p-n junction. For purposes of illustration, the bypass diode 124 is a Schottky bypass diode. External connection terminals 125 and 127 are provided for connecting the solar cell 102 and the diode 124 to other devices, e.g., adjacent solar cell receivers (not shown).

The functionality of the bypass diode 124 can be appreciated by considering multiple solar cells 102 connected in series. Each solar cell 102 can be envisioned as a battery, with the cathode of each of the diodes 124 being connected to the positive terminal of the associated "battery" and the anode of each of the diodes 124 being connected to the negative terminal of the associated "battery." When one of the serially-connected solar cell receivers 100 becomes damaged or shadowed, its voltage output is reduced or eliminated (e.g., to below a threshold voltage associated with the diode 124). Therefore, the associated diode 124 becomes forward-biased, and a bypass current flows only through that diode 124 (and not the solar cell 102). In this manner, the non-damaged or non-shadowed solar cell receivers 100 continue to generate electricity from the solar energy received by those solar cells. If not for the bypass diode 124, substantially all of the electricity produced by the other solar cell receivers would pass through the shadowed or damaged solar cell receiver, destroying it, and creating an open circuit within, e.g., the panel or array. The solar cell receiver 100 also includes a ceramic substrate 126 such as an alumina substrate for mounting of the solar cell 102 and the heat sink 120 for dissipating heat generated by the solar cell 102 during operation.

Figure 2 illustrates the solar cell 102 and the ceramic substrate 126 in more detail. The ceramic substrate 126 has metallized upper and lower surfaces 128 and 130. Both surfaces 128 and 130 of the ceramic substrate 126 are metallized to increase the heat transfer capacity of the ceramic substrate 126, enabling the solar cell receiver 100 to more adequately handle rapid temperature changes that occur due to abrupt changes in solar cell operating conditions. For example, the solar cell 102 generates heat energy when converting light to electricity. Having both the upper and lower surfaces 128 and 130 of the ceramic substrate 126 metallized provides for a faster transfer of the heat energy from the solar cell 102 to the heat sink 120 for dissipation. The opposite condition occurs when the solar cell 102 becomes suddenly shaded. That is, the solar cell 102 stops producing electricity and rapidly cools as does the secondary optical element 104. The metallized upper and lower surfaces 128 and 130 of the ceramic substrate 126 prevent the solar cell 102 from cooling too rapidly by transferring heat energy from the heat sink 120 to the solar cell 102, and depending on the thermal conditions, to the secondary optical element 104 as well. The increased heat transfer capacity of the solar cell receiver 100 reduces the amount of stress imparted to the interface between the solar cell 102 and the ceramic substrate 126 during rapid temperature changes, ensuring a reliable solar cell-to-substrate interface.

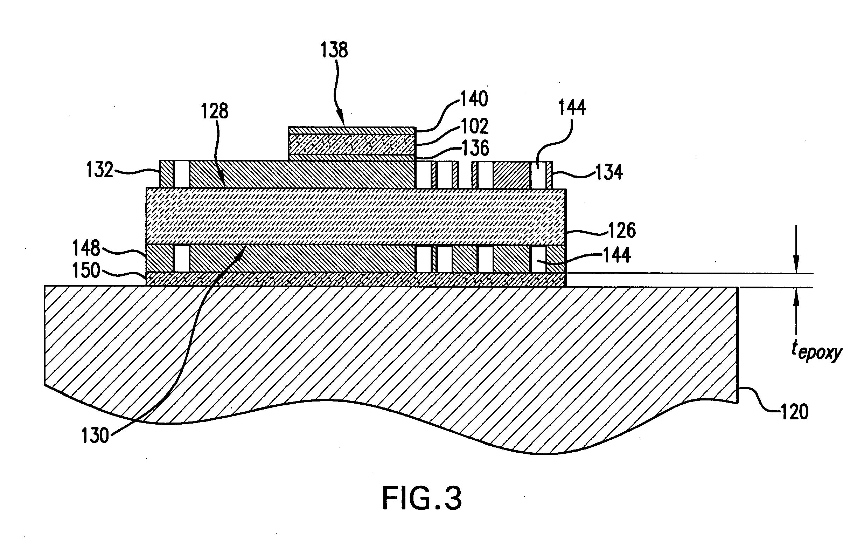

The metallized upper surface 128 of the ceramic substrate 126 is in contact with the solar cell 102 and has separated conductive regions 132 and 134 for providing isolated electrically conductive paths to the solar cell 102. The first conductive region 132 provides an anode electrical contact point for the solar cell 102 and the second conductive region 134 provides a cathode electrical contact point for the solar cell 102. The solar cell 102 has a conductive lower surface 136 out-of-view in Figure 2, but visible in the cross-section of Figure 3 that is positioned on and connected to the first conductive region 132 of the metallized upper surface 128 of the ceramic substrate 126. The opposing upper surface 138 of the solar cell 102 has a conductive contact area 140 connected to the second conductive region 134 of the ceramic substrate 126.

In one embodiment, the conductive lower surface 136 of the solar cell 102 forms an anode terminal of the solar cell 102 and the conductive contact area 140 disposed at the upper surface 138 of the solar cell 102 forms a cathode terminal. According to this embodiment, the conductive lower surface 136 of the solar cell 102 is positioned on the first conductive region 132 of the ceramic substrate 126 and electrically isolated from the second conductive region 134 to ensure proper operation of the solar cell 102. In one embodiment, the first conductive region 132 of the ceramic substrate 126 is at least partly surrounded on three sides by the second conductive region 134 about a periphery region of the ceramic substrate 126.

In one embodiment, the conductive contact area 140 disposed at the upper surface 138 of the solar cell 102 occupies the perimeter of the solar cell 102. In some implementations, the upper conductive contact area 140 can be smaller or larger to accommodate the desired connection type. For example, the upper conductive contact area 140 may touch only one, two or three sides (or portions thereof) of the solar cell 102. In some implementations, the upper conductive contact area 140 is made as small as possible to maximize the area that converts solar energy into electricity, while still allowing electrical connection. While the particular dimensions of the solar cell 102 will vary depending on the application, standard dimensions are about a 1 cm². For example, a standard set of dimensions can be about 12.58 mm x 12.58 mm overall, about 0.160 mm thick, and a total active area of about 108 mm². For example, in a solar cell 102 that is approximately 12.58 mm x 12.58 mm, the upper conductive contact area 140 can be about 0.98 mm wide and the active area can be about 10 mm x 10 mm.

The upper conductive contact area 140 of the solar cell 102 may be formed of a variety of conductive materials, e.g., copper, silver, and/or gold-coated silver. In this implementation, it is the n-conductivity cathode (i.e. emitter) side of the solar cell 102 that receives light, and accordingly, the upper conductive contact area 140 is disposed on the cathode side of the solar cell 102. In one embodiment, the upper conductive contact area 140 of the solar cell 102 is wire bonded to the second conductive region 134 of the metallized upper surface 128 of the ceramic substrate 126 via one or more bonding wires 142.

The bypass diode couples the first conductive region 132 of the metallized upper surface 128 of the ceramic substrate 126 to the second conductive region 134. In one embodiment, a cathode terminal of the bypass diode 124 is connected to the anode terminal of the solar cell 102 via the first conductive region 132 of the ceramic substrate 126 and an anode terminal of the bypass diode 124 is electrically connected to the cathode terminal of the solar cell 102 via the second conductive region 134 of the ceramic substrate 126. The anode terminal of the solar cell 102 is formed by the lower conductive surface 136 of the solar cell 102 as described above and is out-of-view in Figure 2, but visible in the cross-section of Figure 3. The cathode terminal of the solar cell 102 is formed by the upper conductive contact area 140 of the solar cell 102 also as described above. The external connection terminals 125 and 127 disposed on the metallized upper surface 128 of the ceramic substrate 126 provide for electrical coupling of a device to the solar cell 102 and the bypass diode 124. In some implementations, the connector terminals 125 and 127 correspond to anode and cathode terminals, and are designed to accept receptacle plugs (not shown) for connection to adjacent solar cell receivers.

The upper surface 128 of the ceramic substrate 126 can be metallized by attaching metallization layers 132 and 134 to the substrate. In one embodiment, holes 144 are formed in the metallization layers 132, 134. Figure 2 shows the ceramic substrate 126 having two metallization layers 132 and 134 attached to the upper substrate surface 128 (the lower metallized surface is out of view in Figure 2, but visible in the cross-section of Figure 3). Corresponding bumps 146 (out-of-view in Figure 2, but visible in the cross-section of Figure 3) can be formed on the ceramic substrate 102. The bumps 146 are at least partly seated in the holes 144 formed in the metallization layers 132 and 134. The holes 144 in the metallization layers 132 and 134 are then filled with a solder or other type of bonding material such as an adhesive, attaching the metallization layers 132 and 134 to the upper surface 128 of the ceramic substrate 126. The lower surface 130 of the ceramic substrate 126 can be similarly metallized. Alternatively, no bumps are provided on the ceramic substrate 126 and the substrate is relatively planar within normal manufacturing tolerances.

Figure 3 illustrates a cross-sectional view of the solar cell 102, ceramic substrate 126 and heat sink 120 of the solar cell receiver 100 along the line labeled X-X' in Figure 1. The secondary optical element 104, light concentrator 106 and terminals 125, 127 are not shown in Figure 3 for ease of illustration. The upper and lower surfaces 128 and 130 of the ceramic substrate 126 may have bumps 146 that are at least partly seated in holes 144 formed in metallization layers 132, 134 and 148 for attaching the metallization layers to the ceramic substrate 126 as described above. Alternatively, the ceramic substrate 126 is relatively flat within normal manufacturing tolerances. In either case, the upper and lower surfaces 128 and 130 of the ceramic substrate 126 are metallized. The upper metallized surface 128 of the substrate 126 has separated conductive regions 132 and 134 for providing electrically isolated anode and cathode connections to the solar cell 102 as described above.

The solar cell 102 has a conductive lower surface 136 connected to the conductive region 132 of the metallized upper surface 128 of the ceramic substrate 126. In one embodiment, the conductive lower surface 136 of the solar cell 102 forms the anode terminal of the solar cell 102 and the conductive contact area 140 disposed at the upper surface 138 of the solar cell 102 forms the cathode terminal of the solar cell 102. The conductive lower surface 136 of the solar cell 102 is positioned on the first conductive region 132 of the metallized upper surface 128 of the ceramic substrate 126 and electrically isolated from the second conductive region 134 to ensure proper operation of the solar cell 102.

The lower surface 130 of the ceramic substrate 126 also has a metallization layer 148 that is bonded to the heat sink 120 with a highly thermally conductive attach media 150, such as a metal-filled epoxy adhesive or solder. Filling an epoxy adhesive such as silicone with metal increases the thermal conductivity of the interface between the ceramic substrate 126 and the heat sink 120, further improving the heat transfer characteristics of the solar cell receiver 100. In one embodiment, the highly thermally conductive attach media 150 is a metal-filled epoxy adhesive having a thickness *t_{epoxy}* of approximately 1 to 3 mils. The metal-filled epoxy adhesive can be applied to the lower metallized surface 130 of the ceramic substrate 126, the heat sink 120 or both and then cured to bond the heat sink 120 to the substrate 126. In one embodiment, the heat sink 120 is a single-piece extruded aluminum heat sink as shown in Figure 1.

The solar cell receiver 100 can be manufactured by providing the metallized ceramic substrate 126 and connecting the conductive lower surface 136 of the solar cell 102 to the first conductive region 132 of the metallized upper surface 128 of the substrate 126. The conductive contact area 140 disposed at the upper surface 138 of the solar cell 102 is connected to the second conductive region 134 of the metallized upper surface 128 of the ceramic substrate 126, e.g. via one or more bond wires 142. The heat sink 120 is bonded to the lower metallized surface 130 of the ceramic substrate 126 with the metal-filled epoxy adhesive 150.

## Claims

1. A solar cell receiver for converting solar energy to electricity for use in a concentrating photovoltaic system, comprising:
a ceramic substrate having a first metallized surface and an opposing second metallized surface, the first metallized surface having separated conductive regions;
a solar cell having an anode terminal electrically connected to a first one of the conductive regions of the ceramic substrate and a cathode terminal electrically connected to a second one of the conductive regions;
a bypass diode connected across the first and second conductive regions of the ceramic substrate in parallel with the solar cell ; and
a heat sink bonded to the second metallized surface of the ceramic substrate with a thermally conductive attach media.

2. The solar cell receiver of claim 1, wherein the anode terminal of the solar cell is positioned on the first conductive region of the ceramic substrate and electrically isolated from the second conductive region of the ceramic substrate.

3. The solar cell receiver of claim 1, wherein the cathode terminal of the solar cell is wire bonded to the second conductive region of the ceramic and electrically isolated from the first conductive region of the ceramic substrate.

4. The solar cell receiver of claim 1, wherein the solar cell is a triple-junction III-V compound semiconductor solar cell.

5. The solar cell receiver of claim 1, wherein the thermally conductive attach media comprises a metal-filled epoxy adhesive.

6. The solar cell receiver of claim 5, wherein the metal-filled epoxy adhesive has a thickness of approximately 1 to 3 mils.

7. The solar cell receiver of claim 1, wherein an anode terminal of the bypass diode is electrically connected to the cathode terminal of the solar cell and a cathode terminal of the bypass diode is connected to the anode terminal of the solar cell.

8. The solar cell receiver of claim 1, further comprising a secondary optical element with a tapered shape, the secondary optical element including an enlarged inlet that faces away from the solar cell and an smaller outlet that faces towards the solar cell, and including one or more reflective surfaces for reflecting the incoming light from the inlet to the solar cell.

9. The solar cell receiver of claim 8, wherein the secondary optical element is thermally connected to the heat sink.

10. The solar cell receiver of claim 8, further comprising a concentrator positioned between the solar cell and the secondary optical element, the concentrator including a tapered shape with an enlarged first end facing towards the outlet of the secondary optical element and a reduced second end facing towards the solar cell.

11. The solar cell receiver of claim 10, wherein the concentrator is a 2X optical concentrator.

12. The solar cell receiver of claim 1, wherein the conductive contact area of the solar cell is wire bonded to the second conductive region of the ceramic substrate and electrically isolated from the first conductive region of the ceramic substrate.

13. The solar cell receiver of claim 1, wherein the heat sink is an extruded aluminum heat sink having a base and a plurality of planar fins extending outwardly from a line extending along the base.

14. The solar cell receiver of claim 1, wherein the solar cell has a conductive lower surface forming the anode terminal of the solar cell and is positioned on the first conductive region of the ceramic substrate, and electrically isolated from the second conductive region of the ceramic substrate.

15. A method of manufacturing a solar cell receiver for use in a concentrating photovoltaic system, comprising:
providing a ceramic substrate having a first metallized surface and an opposing second metallized surface, the first metallized surface having separated conductive regions;
connecting a conductive first surface of a solar cell to a first one of the conductive regions of the ceramic substrate;
connecting a conductive contact area of an opposing second surface of the solar cell to a second one of the conductive regions; and
bonding a heat sink to the second metallized surface of the ceramic substrate with a metal-filled epoxy adhesive.
